# FASCICULE DE BREVET EUROPEEN

(11) **EP 3 706 274 B1**
(45) Date de publication et mention de la délivrance du brevet: **11.06.2025**
(21) Numéro de dépôt: 20158399.4
(22) Date de dépôt: 20.02.2020
(51) Int. Cl.: H02H 9/04

(54) **DISPOSITIF DE PROTECTION CONTRE LES SURTENSIONS**
SCHUTZVORRICHTUNG GEGEN ÜBERSPANNUNGEN
DEVICE FOR SURGE PROTECTION

(30) Priorité: 05.03.2019 FR 1902245
(43) Date de publication de la demande: 09.09.2020
(73) Titulaire: STMicroelectronics S.r.l., 20864 Agrate Brianza (MB) (IT); STMicroelectronics (Tours) SAS, 37100 Tours (FR)
(72) Inventeur: SIMONNET, Jean-Michel, 37270 VERETZ (FR); NGO, Sophie, 37550 SAINT-AVERTIN (FR); RASCUNA', Simone, 95124 CATANIA (IT)
(74) Mandataire: Cabinet Beaumont

(56) Documents cités:
- US-A1- 2007 023 779
- US-A1- 2010 006 848
- US-A1- 2010 202 090
- US-A1- 2016 372 920
- KIMOTO TSUNENOBU ET AL: "Promise and Challenges of High-Voltage SiC Bipolar Power Devices", ENERGIES, vol. 9, no. 11, 1 November 2016 (2016-11-01), CH, pages 908, XP055881413, ISSN: 1996-1073, DOI: 10.3390/en9110908

## Description

### Domaine technique

La présente description concerne de façon générale les circuits électroniques, et vise plus particulièrement un circuit de protection contre les surtensions.

### Technique antérieure

Un dispositif électronique, par exemple un circuit intégré, a des bornes entre lesquelles il reçoit ou fournit une tension, par exemple une tension d'alimentation ou un signal. La tension a une valeur nominale, pour laquelle le fonctionnement du dispositif est optimal. Le dispositif est parfois soumis à des surtensions. Une surtension tend à donner temporairement à la tension entre les bornes du dispositif une valeur supérieure, en valeur absolue, à la tension nominale.

Afin d'éviter qu'une surtension risque d'altérer le fonctionnement du circuit intégré et/ou de détériorer le circuit intégré, on utilise un circuit électronique de protection contre les surtensions.

### Résumé de l'invention

Un mode de réalisation pallie tout ou partie des inconvénients des dispositifs connus de protection contre les surtensions.

L'invention est exposée dans le jeu de revendications annexé.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente schématiquement un mode de réalisation d'un dispositif comprenant un circuit de protection contre les surtensions ;
la figure 2 représente schématiquement une vue en coupe d'un mode de réalisation selon l'invention d'un circuit de protection contre les surtensions ;
la figure 3 représente schématiquement un autre mode de réalisation selon l'invention d'un dispositif comprenant un circuit de protection contre les surtensions ;
la figure 4 est un diagramme selon l'invention illustrant schématiquement, en fonction de la température, des allures de tensions de seuil de circuits de protection contre les surtensions comprenant différents matériaux semiconducteurs ;
la figure 5 représente schématiquement un autre mode de réalisation qui ne fait pas partie de l'invention d'un dispositif comprenant un circuit de protection contre les surtensions ;
la figure 6 représente schématiquement un autre mode de réalisation qui ne fait pas partie de l'invention d'un dispositif comprenant un circuit de protection contre les surtensions ; et
la figure 7 représente schématiquement un autre mode de réalisation qui ne fait pas partie de l'invention d'un dispositif comprenant des circuits de protection contre les surtensions.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits intégrés à protéger ne sont pas détaillés, les modes de réalisation décrits étant compatibles avec les circuits intégrés usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Divers exemples de mise en œuvre et de réalisation sont exposés par la suite. Indépendamment de la dénomination donnée à ces exemples (modes de réalisation, exemples, variantes, etc.) et des qualificatifs employés (par exemple, de préférence, etc.), seules les parties de description incluses dans la portée des revendications font partie de la présente invention, les autres exemples n'étant exposés qu'à titre illustratif et n'étant utiles que pour mettre en évidence des aspects spécifiques à l'invention par rapport à ce qui n'en fait pas partie.

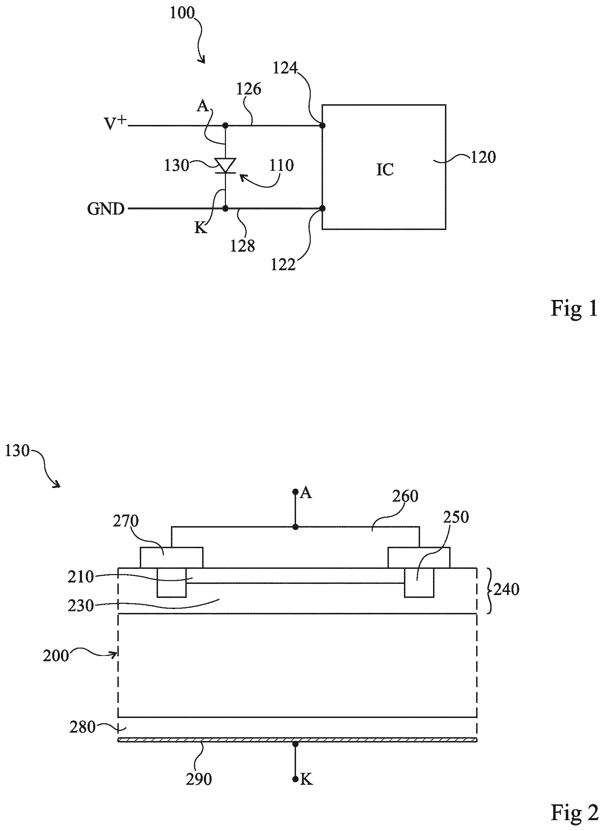

La figure 1 représente schématiquement un mode de réalisation d'un dispositif 100 comprenant un circuit 110 de protection contre les surtensions, et un circuit intégré 120 (IC) protégé contre les surtensions par le circuit 110. Le circuit intégré 120 peut comprendre, ou être constitué par, une puce électronique.

Le circuit 120 a deux bornes 122 et 124 d'entrée/sortie, prévues pour recevoir ou fournir une tension, de préférence une tension positive V+ entre les bornes 124 et 122. Une tension positive entre les bornes 124 et 122 désigne une tension pour laquelle le potentiel de la borne 124 est plus élevé que celui de la borne 122. A titre d'exemple, la tension est appliquée aux bornes 124 et 122 du circuit 120 par l'intermédiaire de liaisons électriquement conductrices respectives 126 et 128. Dans l'exemple représenté, la borne 122 est reliée, de préférence connectée, à un noeud d'application d'un potentiel de référence, par exemple la masse GND.

En fonctionnement, en l'absence de surtension, la tension V+ correspond de préférence à un niveau de tension faible, par exemple inférieur à 5 V, de préférence égal à environ 1,8 V ou à environ 3,3 V. A titre d'exemple, la tension V+ est supérieure à 0,3 V et la tension V+ est une tension d'alimentation, par exemple une tension continue. La tension V+ peut aussi correspondre à un niveau haut de données numériques véhiculées par la liaison 126, en provenance du circuit 120 ou fournies au circuit 120. Dans ce cas, la tension V+ est appliquée de manière discontinue, seulement quand le niveau des données transmises est le niveau haut. La tension V+ peut également correspondre à un niveau crête de signaux analogiques, par exemple reçus par une antenne et fournis au circuit 120, par exemple sous la forme d'une tension alternative superposée à une tension continue. Par exemple, la tension continue est de 0,4 V. De préférence, la tension alternative a une amplitude inférieure à 10 mV, par exemple inférieure à 100 µV ou de l'ordre de quelques µV, c'est-à-dire comprise entre 2 et 10 µV.

Des surtensions risquent de se produire entre les bornes 124 et 122. Une telle surtension peut correspondre à une valeur de la tension entre les bornes 124 et 122 temporairement supérieure à la tension V+, ou à une valeur temporairement négative de cette tension. Une telle surtension se produit typiquement lorsque la liaison 126 est soumise à une décharge électrostatique. Une telle surtension peut aussi provenir d'un élément produisant ou recevant la tension V+, tel qu'une source de tension ou un circuit de fourniture/réception de signaux et/ou de données. Une telle surtension peut également se produire au moment où on connecte cet élément au circuit 120 et/ou au moment où on déconnecte cet élément du circuit 120.

Le circuit 120 comprend des composants, tels que des transistors, des diodes, des éléments capacitifs, etc., soumis à la tension appliquée entre les bornes 124 et 122. Ces composants sont dimensionnés pour une tension maximale de fonctionnement, au-delà de laquelle ils risqueraient d'être endommagés, voire détruits, par la surtension. Le circuit de protection 110 est prévu pour limiter les risques que la surtension détériore les composants du circuit 120.

Dans le présent mode de réalisation, le circuit de protection 110 comprend une diode 130 reliant, de préférence connectant, les bornes 124 et 122. L'anode A de la diode 130 est reliée, de préférence connectée, à la borne 124, et la cathode K de la diode est reliée, de préférence connectée, à la borne 122. Ainsi, la tension positive V+ est appliquée dans le sens direct de la diode 130. De préférence, l'anode A de la diode 130 est reliée, de préférence connectée, à la liaison 126. De préférence, la cathode K de la diode 130 est reliée, de préférence connectée, à la masse. A titre d'exemple, la cathode K de la diode 130 est reliée, de préférence connectée, à la liaison 128.

La diode 130 est en un matériau semiconducteur présentant une largeur de bande interdite (en anglais "gap"), c'est à dire l'écart d'énergie entre bandes de conduction et de valence, supérieure à la largeur de bande interdite du silicium. De préférence, le matériau semiconducteur de la diode 130 est du carbure de silicium. Cependant, les modes de réalisation décrits ne se limitent pas au carbure de silicium, et la diode 130 peut être en tout semiconducteur ayant une bande interdite plus large que celle du silicium, par exemple en nitrure de gallium.

La diode 130 présente une tension de seuil, définie par la tension en direct pour laquelle la diode laisse passer une valeur donnée de courant. Typiquement, cette valeur donnée est de 1 µA. De préférence, la tension de seuil de la diode est comprise entre 2,1 V et 4 V, par exemple, la tension de seuil est comprise entre 2,3 V et 2,4 V.

La tension de seuil est alors plus élevée que celle d'une diode en silicium. De préférence, le semiconducteur est choisi pour que la tension positive V+ entre les bornes du circuit 120 reste, en l'absence de surtension, inférieure à la tension de seuil de la diode 130. Autrement dit, la diode 130 est non passante en l'absence de surtension. La diode 130 a de préférence le courant de fuite le plus faible possible.

Si une surtension se produit et augmente le potentiel de la borne 124, la surtension polarise la diode dans le sens direct. Si la tension aux bornes de la diode 130 dépasse la tension de seuil, la diode 130 devient passante, et la surtension est évacuée vers la masse. Ainsi, même lorsque la surtension se produit, la tension entre les bornes 124 et 122 reste limitée, typiquement à une valeur proche de celle de la tension de seuil de la diode 130. On limite alors le risque que la tension entre les bornes 124 et 122 endommage le circuit 120. Le circuit 120 est donc protégé.

De préférence, le matériau semiconducteur de la diode 130 est en outre choisi de sorte que la diode 130 a une tension de seuil inférieure à, ou de l'ordre de, la tension maximale de fonctionnement du circuit 120. Ainsi, de préférence, la tension de seuil est comprise entre la tension V+ et la tension maximale de fonctionnement du circuit 120. Le circuit de protection 110 permet alors, en passant de l'état non passant en l'absence de surtension à l'état passant pendant la surtension, d'éviter que la tension entre les bornes 124 et 122 dépasse la tension maximale de fonctionnement. Il n'y a donc pas de risque que la tension entre les bornes 124 et 122 endommage le circuit 120. Le circuit est alors mieux protégé que si la tension de seuil est supérieure à la tension maximale de fonctionnement.

Afin d'obtenir un circuit qui protège contre des surtensions supérieures à un seuil donné et qui soit non passant en l'absence de surtension, on aurait pu penser utiliser une diode polarisée en inverse, cette diode présentant un seuil de tension Zener. Cependant, pour une tension de seuil Zener égale à la tension de seuil de la diode 130, le courant de fuite circulant en l'absence de surtension dans la diode Zener serait supérieur au courant de fuite passant par la diode 130. Ainsi, la diode 130 permet, par rapport à une diode polarisée en inverse, un courant de fuite réduit, et permet donc de limiter la consommation d'énergie par le dispositif 100 en l'absence de surtension. En outre, dans le cas où la liaison 126 constitue une ligne de transmission de signaux, ces signaux sont d'autant plus déformés que le courant de fuite est élevé. Une déformation trop importante pourrait rendre ces signaux inutilisables. Par rapport à une diode Zener, la diode 130 améliore la qualité des signaux transmis. De plus, la diode 130 évite le risque que les signaux soient trop déformés pour être utilisables.

Afin d'obtenir un circuit qui protège contre des surtensions supérieures à un seuil donné et qui soit non passant en l'absence de surtension, on aurait également pu penser utiliser des diodes en silicium reliées électriquement en série entre les bornes 122 et 124, les anodes des diodes étant tournées vers la borne 124. La tension de seuil de l'association en série des diodes correspond alors à la somme des seuils de tension des diodes. Cependant, pour une tension de seuil de l'association en série des diodes en silicium égale à la tension de seuil de la diode 130, le courant de fuite circulant en l'absence de surtension dans l'association série serait supérieur au courant de fuite passant par la diode 130. Ainsi, la diode 130 permet, par rapport à une association en série de diodes en silicium, un courant de fuite réduit, et permet donc de limiter la consommation d'énergie par le dispositif 100 en l'absence de surtension.

A titre d'exemple, pour une association en série de huit diodes en silicium, une tension de seuil de l'association série comprise entre 2,3 et 2,4 V, et un potentiel V+ (référencé à la masse) égal à 1,8 V on mesure un courant de fuite de l'ordre de 45 nA. Pour ce même potentiel V+ de 1,8 V, la diode 130, dans le cas où elle est en carbure de silicium, laisse typiquement passer moins de 1 nA. Par ailleurs, la protection contre les surtensions est assurée par une diode 130 unique, qui est plus facile à intégrer et occupe moins de place qu'une association série de plusieurs diodes, par exemple de huit diodes.

De plus, on aurait pu penser utiliser dans le circuit de protection un transistor ou un thyristor déclenché par effet d'avalanche avec effet de retournement pour limiter la tension lors de l'application de la surtension, et, afin de limiter le courant de fuite, choisir une tension d'avalanche supérieure à la tension maximale de fonctionnement du circuit à protéger. Cependant, la tension appliquée au circuit à protéger atteindrait en début de surtension un pic de déclenchement de l'avalanche. Le circuit à protéger ne serait donc protégé qu'après ce pic de tension. Contrairement à un circuit de protection déclenché par un effet d'avalanche, la diode 130 devient passante dès que la tension V+ dépasse la tension de seuil de la diode. Ainsi, la tension entre les bornes 124 et 122 du circuit à protéger 120 reste inférieure à la tension maximale de fonctionnement dès le début de la surtension. De ce fait, la protection par la diode 130 est améliorée par rapport à un circuit de protection déclenché par effet d'avalanche, même avec un effet de retournement. En outre, la diode 130 présente, par rapport à un circuit comprenant des transistors, l'avantage d'être plus simple à réaliser.

La figure 2 représente schématiquement une vue en coupe d'un mode de réalisation d'un circuit de protection contre les surtensions. Plus précisément, la figure 2 représente une diode 130 du type décrit ci-dessus en relation avec la figure 1.

La diode 130 comprend un substrat 200, en un semiconducteur présentant une largeur de bande interdite supérieure à celle du silicium, de préférence en carbure de silicium. De préférence, le carbure de silicium a le polytype 4H ou 6H. Les modes de réalisation décrits ne se limitent pas aux polytypes 4H et 6H, et sont compatibles avec tout polytype du carbure de silicium, par exemple le polytype 3C. De préférence, le substrat 200 est dopé de type N. Plus préférentiellement, le substrat 200 est dopé de type N+, c'est à dire à un niveau de dopage compris entre 5*10^16 et 5*10^18 atomes/cm^3 (où le signe "^" représente la fonction exposant) . L'épaisseur du substrat est par exemple comprise entre 100 µm et 350 µm

La diode 130 comprend une région 210 dopée de type P recouvrant la face supérieure du substrat 200, c'est-à-dire la face avant du substrat 200. La région 210 dopée de type P forme, avec le substrat 200 dopé de type N, une jonction PN.

De préférence, la diode 130 comprend en outre une région 230 en un matériau semiconducteur intrinsèque située entre la région 210 et le substrat 200. On appelle ici semiconducteur intrinsèque, un semiconducteur non intentionnellement dopé, ou dont le niveau de dopage est inférieur à 5*10^16 atomes/cm^3. Le matériau semiconducteur de la région 230 est de préférence le même, au dopage près, que celui du substrat 200. La région 230 est préférentiellement en carbure de silicium, cependant les modes de réalisation décrits ne sont pas limités au carbure de silicium. De préférence, le carbure de silicium de la région intrinsèque 230 a le même polytype que le substrat 200. On peut prévoir, entre le substrat 200 et la région intrinsèque 230, une couche tampon (non représentée). Le matériau de cette couche tampon est le même que celui du substrat 200 et de la région intrinsèque 230, et a un niveau de dopage entre ceux du substrat 200 et de la région intrinsèque 230.

La région 210 dopée de type P, et la région intrinsèque 230, sont de préférence situées dans une même couche semiconductrice 240. Plus précisément, pour former les régions 230 et 210, on forme d'abord la couche 240, de préférence sous forme intrinsèque. De préférence, la couche 240 résulte d'une étape de croissance par épitaxie sur la face avant du substrat 200. Ensuite, on dope une partie supérieure de la couche 240 pour former la région 210, et on laisse intrinsèque la partie inférieure de la couche 240. La partie laissée intrinsèque constitue la région 230. En variante, la région 210 peut être dopée au cours de sa formation par épitaxie.

De préférence, la région 210 occupe sur le substrat une surface comprise entre 100 µm^2 et 0,1 mm^2. La région 210 est dopée préférentiellement par des atomes d'aluminium ou de bore. Le niveau de dopage de la région 210 dopée de type P est de préférence supérieur à 10^18 atomes/cm^3. La région 210 a de préférence une épaisseur sensiblement constante, par exemple comprise entre 20 nm et 1 µm. L'épaisseur de la couche 240 est de préférence comprise entre 100 nm et 10 µm.

De préférence, on forme en outre une région annulaire 250 dopée de type P autour de la région 210. La région annulaire 250 s'étend à partir de la face avant (supérieure) de la couche 240 jusqu'à un niveau situé dans la région intrinsèque 230 et en dessous du niveau inférieur de la région 210 dopée de type P. De préférence, la région annulaire 250 entoure complètement la région 210. De préférence, la région annulaire 250 a un flanc intérieur en contact avec les flancs de la région 210.

La région 210 est recouverte par une région électriquement conductrice 260. La région conductrice 260 est par exemple en un matériau métallique. La région conductrice 260 est en contact avec la région 210 dopée de type P et forme une prise de contact d'anode. La région conductrice 260 forme, ou est reliée à, de préférence connectée à, la borne A de la diode 130.

De préférence, on prévoit un isolant électrique 270, par exemple en oxyde de silicium, qui isole entre elles la région conductrice 260 et la région annulaire 250. L'isolant 270 recouvre entièrement la région annulaire 250, et s'étend de préférence sur une partie des bords de la région 210.

Le substrat 200 est recouvert côté face arrière d'une couche conductrice 290, par exemple métallique, qui forme avec la région 200 une prise de contact de cathode de la diode 130 (par l'intermédiaire d'une région dopée 280). La couche forme, ou est reliée à, de préférence connectée à, la borne de cathode K de la diode.

Dans la diode 130, la région intrinsèque 230 située entre les régions 210 d'anode et 200 de cathode de la diode, permet, par rapport à une diode dépourvue d'une telle région intrinsèque, de réduire la capacité parasite présentée par la diode entre sa cathode et son anode. A titre d'exemple, la capacité parasite de la diode 130 est inférieure à 200 pF/mm^2. Dans le cas où des données sont véhiculées par la liaison 126 (figure 1), les données peuvent être véhiculées à un débit d'autant plus élevé que la capacité parasite de la diode est faible. Ainsi, avec la diode 130 comprenant la région intrinsèque 230, le circuit 120 peut fournir et/ou recevoir des données à un débit plus élevé qu'avec une diode dépourvue d'une telle région intrinsèque.

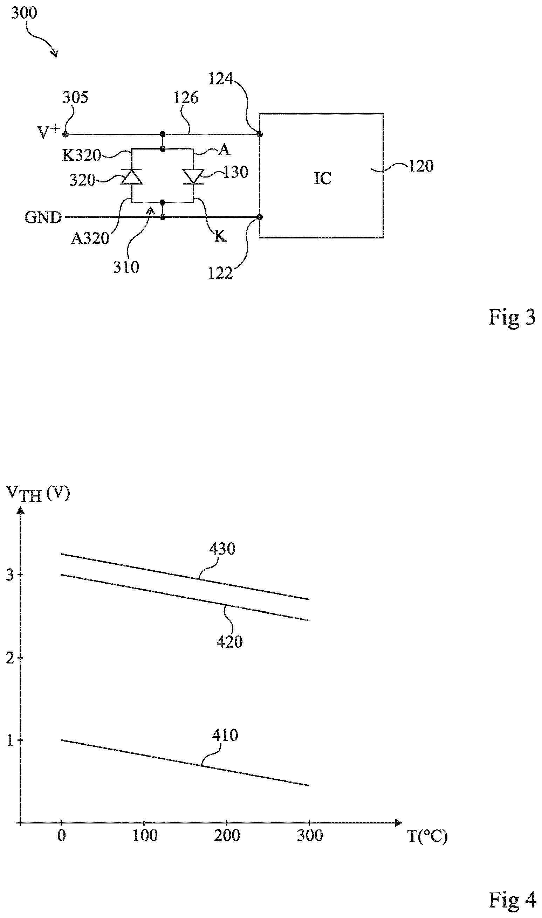

La figure 3 représente schématiquement un autre mode de réalisation d'un dispositif 300 comprenant un circuit 310 de protection contre les surtensions, et un circuit 120 protégé contre les surtensions par le circuit 310.

Le circuit 120 comprend des éléments identiques ou similaires à ceux du circuit 120 de la figure 1, à savoir deux bornes 122 et 124 prévues pour recevoir ou fournir une tension. Cette tension correspond de préférence à la tension positive V+ de la figure 1, à savoir, à une tension d'alimentation, ou à un niveau haut de données numériques véhiculées par la liaison 126, ou encore à un niveau crête de signaux analogiques, ou encore à toute tension nominale positive appliquée au circuit 120 ou provenant du circuit 120. Dans l'exemple représenté, les bornes 124 et 122 sont reliées, de préférence connectées, à des noeuds d'application 305 et GND de la tension V+.

Le circuit de protection 310 comprend, comme le circuit de protection 110 de la figure 1, une diode 130 en un matériau semiconducteur présentant une largeur de bande interdite supérieure à celle du silicium, de sorte à assurer une protection contre des surtensions tendant à augmenter la tension entre les bornes 124 et 122. La diode 130 a son anode A reliée, de préférence connectée, à la borne 124 du circuit 120, et sa cathode K reliée, de préférence connectée, à la borne 122 du circuit 120. Ainsi, la diode 130 protège le circuit 120 contre des surtensions tendant à provoquer, entre les bornes 124 et 122, une valeur de tension positive supérieure à un seuil, et la diode 130 est non passante en l'absence de surtension.

Le circuit de protection 310 comprend en outre, électriquement en parallèle de la diode 130, une diode 320. Les diodes 130 et 320 sont positionnées tête-bêche. Ainsi, la diode 320 a son anode A320 reliée, de préférence connectée, à la borne 122 du circuit 120. La cathode K320 de la diode 320 est reliée, de préférence connectée, à la borne 124 du circuit 120.

Selon un premier mode de réalisation, la diode 320 est en silicium, ou en un matériau semiconducteur ayant une largeur de bande inférieure à celle du silicium. En variante, la diode 320 est de type Schottky.

En cas de surtension tendant à rendre négative la tension entre les bornes 124 et 122, la diode 320 devient passante dès que la tension négative devient, en valeur absolue, supérieure à la tension de seuil de la diode. En outre, la diode 320 est à l'état non passant lorsque la tension entre les bornes 124 et 122 est positive en l'absence de surtension. De plus, la diode 320 est non passante lorsque cette tension est nulle ou sensiblement nulle, c'est-à-dire nulle à 0,2 V près, de préférence à 0,1 V près. Une telle tension nulle ou sensiblement nulle correspond typiquement à un niveau bas de données véhiculées par la liaison 126.

Dans le premier mode de réalisation, le circuit de protection 310 protège donc le circuit 120 à la fois contre toute surtension tendant à provoquer une élévation de la tension entre les bornes 124 et 122, et contre toute surtension tendant à rendre cette tension négative. De plus, en l'absence de surtension, le circuit de protection est non passant lorsque la tension entre les bornes 124 et 122 est positive et inférieure à la tension de seuil de la diode 130, et lorsque cette tension est nulle ou sensiblement nulle.

Selon un deuxième mode de réalisation, la diode 320 est en un matériau semiconducteur ayant une largeur de bande interdite supérieure à celle du silicium. En cas de surtension tendant à rendre négative la tension entre les bornes 124 et 122, la diode 320 devient passante dès que la tension négative devient, en valeur absolue, supérieure à la tension de seuil de la diode.

En outre, du fait que la largeur de bande interdite du matériau de la diode 320 est supérieure à celle du silicium, la diode reste non passante lorsque la tension entre les bornes 124 et 122 est faiblement négative, par exemple, en valeur absolue, inférieure à 5 V, de préférence égale à environ 1,8 V ou à environ 3,3 V. De ce fait, le circuit 120 peut être configuré pour fonctionner avec une tension négative entre les bornes 124 et 122, de préférence une tension supérieure en valeur absolue à 0,3 V, plus préférentiellement, supérieure en valeur absolue à 0,6 V.

Dans le deuxième mode de réalisation, le circuit de protection 310 protège donc le circuit 120 à la fois contre toute surtension tendant à provoquer une augmentation, en valeur absolue, de la tension entre les bornes 124 et 122. De plus, en l'absence de surtension, le circuit de protection est non passant lorsque la tension entre les bornes 124 et 122 est négative et inférieure, en valeur absolue, au seuil de la tension de la diode 320, et lorsque cette tension est positive et inférieure à la tension de seuil de la diode 130.

De préférence, le matériau semiconducteur est le même pour les diodes 130 et 320. De préférence, les diodes 130 et 320 sont en carbure de silicium ayant le même polytype. On obtient ainsi des valeurs de seuils des diodes identiques en valeur absolue. La tension entre les bornes 124 et 122 en l'absence de surtension peut être une tension alternative, c'est à dire alternativement positive et négative. La tension alternative est par exemple symétrique par rapport à la tension nulle. La protection est alors assurée de manière symétrique par rapport à la tension nulle. Une telle tension alternative peut provenir typiquement d'une alimentation, ou encore, par exemple, d'une antenne. La tension alternative peut aussi être fournie par le circuit 120. Le circuit 130 est compatible avec toute tension alternative d'amplitude crête inférieure à la tension de seuil des diodes 130 et 320.

De préférence, les diodes 130 et 320 comprennent chacune une couche intrinsèque entre leurs régions dopées de cathode et d'anode. Les diodes 130 et 320 sont de préférence du type de la diode de la figure 2, et peuvent comprendre une région semiconductrice intrinsèque entre les régions semiconductrices d'anode et de cathode. Les capacités parasites des deux diodes sont alors réduites, comme ceci a été détaillé en relation avec la figure 2. La fréquence de la tension alternative peut alors être plus élevée avec un circuit comprenant de telles couches intrinsèques, qu'avec un circuit dépourvu de ces couches intrinsèques.

La figure 4 est un diagramme illustrant schématiquement, en fonction de la température (en abscisses, en °C), des allures de tensions de seuil V_{TH} (en ordonnées, en V). Plus précisément, on a représenté la tension de seuil 410 d'une diode en silicium, et des tensions de seuils 420 et 430 de circuits de protection selon les modes de réalisation décrits ci-dessus. La tension de seuil 420 correspond à un circuit de protection comprenant une diode en carbure de silicium ayant le polytype 6H, et la tension de seuil 430 correspond à un circuit de protection comprenant une diode en carbure de silicium ayant le polytype 4H.

Les tensions de seuil 410, 420 et 430 diminuent lorsque la température augmente. La tension de seuil 410 de la diode en silicium diminue de plus de 40 % lorsque la température augmente de 0°C à 300°C. Les tensions de seuil 420 et 430 des diodes en carbure de silicium diminuent de moins de 15 % lorsque la température augmente de 0°C à 300°C. La tension de seuil diminue d'un pourcentage d'autant plus faible que la largeur de bande interdite du semiconducteur est élevée. Ainsi, les diodes en un matériau semiconducteur à largeur de bande interdite supérieure à celle du silicium ont des tensions de seuil qui diminuent relativement moins, lorsque la température s'élève, que la tension de seuil d'une diode en silicium. De ce fait, les modes de réalisation des circuits de protection 110 et 310 des figures 1 et 3 ont, lorsque la température s'élève, des tensions de seuil qui diminuent moins que celle d'une association en série de diodes en silicium.

Comme ceci a été mentionné ci-dessus, la tension de seuil de la diode 130 est de préférence comprise entre la tension V+ appliquée au circuit 120, et la tension maximale de fonctionnement admissible par le circuit à protéger. Ceci se produit dans une plage de températures d'autant plus large que les variations de la tension de seuil en fonction de la température sont réduites. Ainsi, les circuits de protection des modes de réalisation décrits ci-dessus ont des plages de température de fonctionnement plus larges que celle d'un circuit de protection basé sur des diodes en silicium associées en série. A titre d'exemple, la plage de température de fonctionnement du circuit de protection 110 de la figure 1 et du circuit 310 de la figure 3 est comprise entre -40°C et 125°C, de préférence entre -20°C et 85°C

La tension de seuil 420 du carbure de silicium ayant le polytype 6H est inférieure à la tension de seuil 430 du carbure de silicium ayant le polytype 4H. Ceci illustre que la tension de seuil de la diode 130, lorsque celle-ci est en carbure de silicium, dépend du polytype du carbure de silicium. De préférence, le polytype du carbure de silicium est sélectionné en fonction de la tension de seuil visée (liée principalement à la tension V+ nécessaire pour le bon fonctionnement du circuit intégré 120) et/ou de la plage de températures de fonctionnement visée.

Cette sélection du polytype peut être effectuée au cours de la conception du circuit de protection 110. Le matériau semiconducteur peut également être constitué par tout matériau semiconducteur ayant plusieurs polytypes et ayant une largeur de bande interdite supérieure à celle du silicium. La sélection du polytype parmi ces plusieurs polytypes est effectuée d'une manière similaire à celle décrite ci-dessus pour le carbure de silicium.

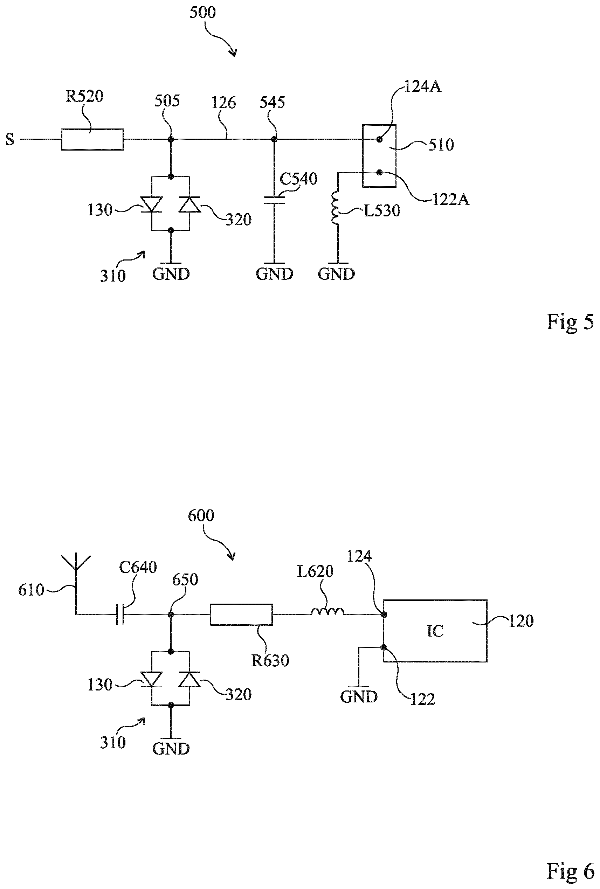

La figure 5 représente schématiquement un autre mode de réalisation d'un dispositif 500 comprenant un circuit de protection contre les surtensions. Le circuit de protection est par exemple un circuit du type du circuit 310 décrit en relation avec la figure 3. Ainsi, le circuit 310 comprend des diodes 130 et 320 tête-bêche en parallèle (autrement dit, les diodes 130 et 320 sont anti-parallèles) entre la masse GND et un noeud 505 de connexion à la liaison 126. La diode 130 a son anode tournée du côté du noeud 505, et sa cathode tournée du côté de la masse. Comme dans les modes de réalisation précédents, la diode 130 est en un semiconducteur ayant une largeur de bande interdite supérieure à celle du silicium. La diode 320 peut être en silicium ou en en semiconducteur ayant une largeur de bande interdite supérieure à celle du silicium.

Le dispositif comprend un connecteur 510 destiné à être connecté à un câble d'alimentation ou de communication de signaux et/ou de données, non représenté. La liaison 126 est destiné à être connectée à un circuit à protéger, non représenté. La liaison 126 relie une borne 124A du connecteur 510 à une résistance R520. Le connecteur 510 comprend en outre une borne 122A reliée à la masse, par exemple par une inductance L530. Une capacité C540 est reliée, de préférence connectée, entre la masse et un noeud 545 de connexion à la liaison 126. Le noeud 545 peut être situé, entre le noeud 505 et la résistance R520, ou être situé, comme représenté, entre le noeud 505 et le connecteur 510. La résistance R520 est reliée à un noeud d'application d'un signal de données S ou d'alimentation du circuit à protéger.

Le signal de donnés S a de préférence des niveaux bas et haut de potentiel, référencés par rapport à la masse. De préférence, le niveau haut correspond à un potentiel positif, et le niveau bas correspond à un potentiel sensiblement nul. La résistance R520, la capacité C540, et l'inductance L530 jouent des rôles de filtres. Chacune des diodes 130 et 320 comprend préférentiellement une région intrinsèque, telle que la région intrinsèque 230 de la figure 2, entre les régions dopées d'anode et de cathode. Comme ceci a été mentionné, le débit de données peut être plus élevé lorsque cette région intrinsèque est prévue, que lorsque les diodes sont dépourvues de cette région intrinsèque.

La figure 6 représente schématiquement un autre mode de réalisation d'un dispositif 600 comprenant un circuit de protection contre les surtensions. Plus précisément, le dispositif 600 est un dispositif de réception d'ondes radiofréquences.

Le dispositif 600 comprend un circuit 120 à protéger contre les surtensions. Le circuit 120 est par exemple un circuit de réception d'un système de positionnement par satellite (GNSS, "Global Navigation Satellite System")

Le circuit 120 a une borne 122 reliée à la masse et une borne 124. La borne 124 est une borne de réception d'un signal d'une antenne 610. La borne 124 est reliée à l'antenne 610 par une inductance L620, une résistance R630, et une capacité C640 électriquement en série. A titre d'exemple, l'inductance est du côté du circuit 120 et la capacité C640 est du côté de l'antenne 610.

Le dispositif comprend en outre un circuit de protection 310 du type de celui de la figure 3. Ainsi, le circuit 310 comprend des diodes 130 et 320 tête-bêche électriquement en parallèle. La cathode de la diode 130 et l'anode de la diode 320 sont reliées, de préférence connectées, entre elles et à la masse. L'anode de la diode 130 et la cathode de la diode 320 sont reliées ensemble à un noeud de connexion 650 entre la capacité C640 et la résistance R630. La cathode de la diode 320 et l'anode de la diode 130 peuvent également être reliées ensemble à n'importe quel autre noeud de l'association en série de la résistance R630, de l'inductance L620 et de la capacité C640.

Comme dans les modes de réalisation précédents, la diode 130 est en un semiconducteur ayant une largeur de bande interdite supérieure à celle du silicium. La diode 320 est de préférence en silicium.

Des ondes radiofréquences reçues par l'antenne 610 provoquent des variations alternatives de la tension aux bornes du circuit de protection 310, superposées à une tension continue de l'ordre de 0,4 V fournie par le circuit 120. la capacité C640 évite que la tension continue atteigne l'antenne. Comme ceci a été mentionné, le courant de fuite passant à travers les diodes est réduit par rapport au courant de fuite dans un dispositif à base de diode à effet Zener ou d'avalanche, ou par rapport à un dispositif basé sur une association série de diodes en silicium. Ce courant de fuite correspond à une partie du signal reçu par l'antenne 610 qui ne parvient pas au circuit 120. En réduisant le courant de fuite, on augmente ainsi la part du signal qui est effectivement reçue par le circuit 120. Le dispositif 600 a donc une sensibilité accrue de réception des ondes radiofréquences.

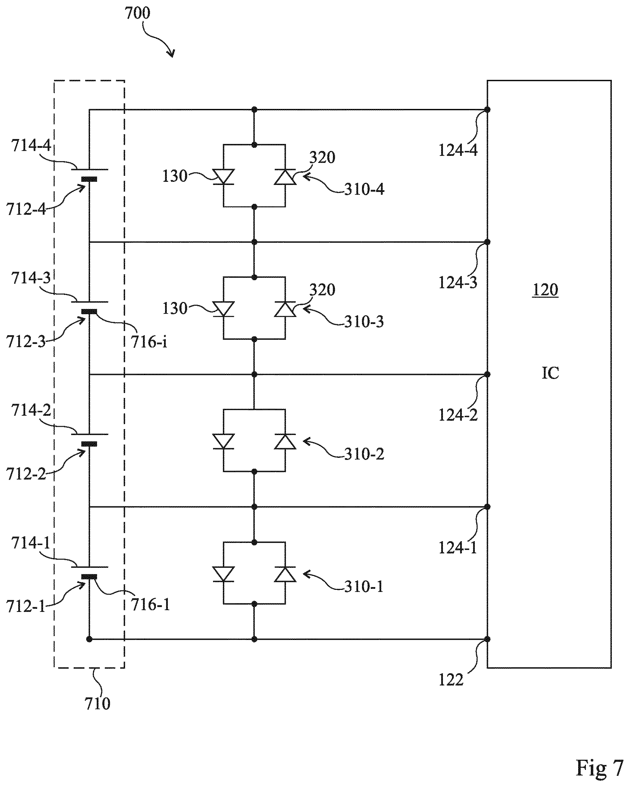

La figure 7 représente schématiquement un autre mode de réalisation d'un dispositif 700 comprenant des circuits de protection contre les surtensions.

Le dispositif 700 comprend une batterie 710, par exemple une batterie au lithium. La batterie 710 comprend des éléments 712_i reliés en série, i étant un entier compris entre 1 et N. Dans l'exemple représenté, N=4 et la batterie 710 comprend quatre éléments 712_1, 712_2, 712_3 et 712_4. Chaque élément 712_i correspond par exemple à une cellule électrochimique élémentaire. Chaque élément 712_i a une borne positive 714_i (714_1, 714_2, 714_3 et 714_4) et une borne négative 716_i. La borne négative 716_i de chaque élément 712_i, autre que le premier élément, 712_1, de l'association en série, est reliée, de préférence connectée, à la borne positive de l'élément précédent de l'association en série.

La batterie 710 est reliée, de préférence connectée, à un circuit intégré 120 (IC). Le circuit 120 est par exemple un circuit de contrôle de charge et de décharge de la batterie, de préférence de type BMS ("battery management system"). En particulier, chaque borne positive 714_i est reliée, de préférence connectée, à une borne 124_i (124_1, 124_2, 124_3, 124_4) du circuit 120. La borne négative 716_1 du premier élément, 712_1, de l'association en série est reliée à une borne 122 du circuit 120. Les bornes 124_i correspondent par exemple à des entrées analogiques de mesure des tensions aux bornes des éléments 712_i.

Pour chaque élément 712_i, le dispositif 700 comprend un circuit de protection 310_i (310_1, 310_2, 310_3, 310_4) électriquement en parallèle avec l'élément 712_i. Ainsi, chaque circuit 310_i comprend des diodes 130 et 320 tête-bêche électriquement en parallèle avec l'élément 712_i. Comme dans les modes de réalisation précédents, la diode 130 est en un semiconducteur ayant une largeur de bande interdite supérieure à celle du silicium. La diode 320 est de préférence en silicium.

Les courants de fuite passant à travers les diodes 130 sont réduits par rapport à des courants de fuite dans des circuits de protection comprenant des diodes de type Zener ayant des tensions de seuil par exemple inférieures à 5 V, ou comprenant des associations en série de diodes en silicium. Ainsi, par rapport à de tels circuits de protection, les circuits 310_i permettent d'améliorer la mesure et le contrôle de la tension des éléments 712_i de la batterie lors de la charge et/ou de la décharge.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, on peut prévoir une ou plusieurs diodes supplémentaires en série avec chaque diode en un matériau semiconducteur ayant une largeur de bande interdite supérieure à celle du silicium. Cette ou ces diodes supplémentaires peuvent être en silicium ou en un matériau semiconducteur ayant une largeur de bande interdite supérieure à celle du silicium.

En outre, les types N et P de conductivités des modes de réalisation décrits peuvent être inversés en même temps que les signes des tensions et des surtensions décrites.

Enfin, la mise en oeuvre pratique des modes de réalisation et variantes décrits est à la portée de l'homme du métier à partir des indications fonctionnelles données ci-dessus selon les revendications annexées.

## Revendications

1. Circuit de protection contre les surtensions (110 ; 310) comprenant :
- une première diode (130) en un matériau semiconducteur présentant une largeur de bande interdite supérieure à celle du silicium, la première diode ayant son anode et sa cathode situées sur des faces opposées d'un substrat (200) et comportant :
une première région (200) dopée de type N, respectivement P ;
une deuxième région (210), dopée de type P, respectivement N ;
une région intrinsèque (230) entre la première et la deuxième région ;
une région annulaire (250), entourant la deuxième région et s'étendant dans la région intrinsèque (230) ; et
- une deuxième diode (320) en silicium en antiparallèle avec la première diode.

2. Circuit selon la revendication 1, dans lequel le semiconducteur est du carbure de silicium.

3. Circuit selon la revendication 2, dans lequel le carbure de silicium a le polytype 4H ou 6H.

4. Circuit selon la revendication 1, dans lequel le semiconducteur est du nitrure de gallium.

5. Circuit selon l'une quelconque des revendications 1 à 4, configuré pour assurer ladite protection lorsque les surtensions polarisent la première diode (130) dans le sens direct.

6. Circuit selon l'une quelconque des revendications 1 à 5, configuré pour que, en l'absence de surtension, une tension soit appliquée dans le sens direct de la première diode.

7. Dispositif comprenant au moins un premier circuit (110 ; 310) selon l'une quelconque des revendications 1 à 6 et un deuxième circuit (120), le premier circuit reliant des bornes (122, 124) du deuxième circuit entre elles.

8. Dispositif selon la revendication 7, dans lequel lesdites bornes (122, 124) sont des bornes d'entrée/sortie du deuxième circuit (120).

9. Circuit selon l'une quelconque des revendications 1 à 6, ou dispositif selon la revendication 7 ou 8, dans lequel ledit semiconducteur a un polytype 4H ou 6H.

## Patentansprüche

1. Überspannungsschutzschaltung (110; 310), aufweisend:
- eine erste Diode (130) aus einem Halbleitermaterial mit einer Bandlückenbreite, die größer ist als die von Silizium, wobei die Anode und die Kathode der ersten Diode auf gegenüberliegenden Seiten eines Substrats (200) angeordnet sind, und Folgendes aufweisen:
einen ersten Bereich (200), der vom N-Typ bzw. P-Typ dotiert ist;
einen zweiten Bereich (210), der vom P-Typ bzw. N-Typ dotiert ist;
einen intrinsischen Bereich (230) zwischen den ersten und zweiten Bereichen;
einen Ringbereich (250), der den zweiten Bereich umgibt und sich innerhalb des intrinsischen Bereichs (230) erstreckt; und
- eine zweite Diode (320) aus Silizium, die antiparallel zur ersten Diode geschaltet ist.

2. Schaltung nach Anspruch 1, wobei der Halbleiter Siliziumkarbid ist.

3. Schaltung nach Anspruch 2, wobei das Siliziumkarbid den 4H- oder 6H-Polytyp aufweist.

4. Schaltung nach Anspruch 1, wobei der Halbleiter Galliumnitrid ist.

5. Schaltung gemäß einem der Ansprüche 1 bis 4, die konfiguriert ist zum Vorsehen des Schutzes, wenn die Überspannung die erste Diode (130) in Durchlassrichtung polt.

6. Schaltung gemäß einem der Ansprüche 1 bis 5, die so konfiguriert ist, dass bei Abwesenheit einer Überspannung eine Spannung in Durchlassrichtung der ersten Diode angelegt wird.

7. Vorrichtung, die mindestens eine erste Schaltung (110; 310) gemäß einem der Ansprüche 1 bis 6 und eine zweite Schaltung (120) aufweist, wobei die erste Schaltung Anschlüsse (122, 124) der zweiten Schaltung miteinander koppelt.

8. Vorrichtung nach Anspruch 7, wobei die Anschlüsse (122, 124) Eingangs-/Ausgangsanschlüsse der zweiten Schaltung (120) sind.

9. Schaltkreis nach einem der Ansprüche 1 bis 6 oder Vorrichtung nach Anspruch 7 oder 8, wobei der Halbleiter den 4H- oder 6H-Polytyp aufweist.

## Claims

1. Overvoltage protection circuit (110; 310) comprising:
- a first diode (130) made of a semiconductor material having a bandgap width greater than that of silicon, first diode having its anode and its cathode located on opposite faces of a substrate (200), and including:
a first region (200) doped of the N-type, respectively P-type;
a second region (210) doped of the P-type, respectively N-type;
an intrinsic region (230) between the first and second regions;
a ring region (250) surrounding the second region and extending within the intrinsic region (230); and
- a second diode (320) made of silicon in antiparallel to the first diode.

2. Circuit according to claim 1, wherein the semiconductor is silicon carbide.

3. Circuit according to claim 2, wherein the silicon carbide has the 4H or 6H polytype.

4. Circuit according to claim 1, wherein the semiconductor is gallium nitride.

5. Circuit according to any one of claims 1 to 4, configured to provide said protection when overvoltage biases the first diode (130) in the forward direction.

6. Circuit according to any one of claims 1 to 5, configured so that, in the absence of an overvoltage, a voltage is applied in the forward direction of the first diode.

7. Device comprising at least one first circuit (110; 310) according to any one of claims 1 to 6 and one second circuit (120), the first circuit coupling terminals (122, 124) of the second circuit to each other.

8. Device according to claim 7, wherein said terminals (122, 124) are input/output terminals of the second circuit (120).

9. Circuit according to any one of claims 1 to 6, or device according to claim 7 or 8, wherein said semiconductor has the 4H or 6H polytype.
